# EUROPÄISCHE PATENTSCHRIFT

(11) **EP 2 245 680 B1**
(45) Veröffentlichungstag und Bekanntmachung des Hinweises auf die Patenterteilung: **18.01.2012**
(21) Anmeldenummer: 09714000.8
(22) Anmeldetag: 04.02.2009
(51) Int. Cl.: H01L 41/24

(54) **VERFAHREN ZUM POLARISIEREN EINER PIEZOKERAMIK**
METHOD FOR POLARIZING A PIEZOCERAMIC MATERIAL
PROCÉDÉ DE POLARISATION D UN ÉLÉMENT PIÉZOCÉRAMIQUE

(30) Priorität: 27.02.2008 DE 102008011414
(43) Veröffentlichungstag der Anmeldung: 03.11.2010
(73) Patentinhaber: Continental Automotive GmbH, 30165 Hannover (DE)
(72) Erfinder: REICHINGER, Christian, 93073 Neutraubling (DE)
(86) Internationale Anmeldenummer: PCT/EP2009/051253
(87) Internationale Veröffentlichungsnummer: WO 2009/106410

(56) Entgegenhaltungen:
- DE-A1- 10 028 335
- JP-A- 2008 053 285
- US-A1- 2006 238 073
- US-A1- 2008 030 102

## Beschreibung

Die Erfindung betrifft ein Verfahren zum Polarisieren einer Piezokeramik.

Piezokeramische Materialien, wie z.B. Blei-Zirkonat-Titanat, dehnen sich bei einer angelegten elektrischen Spannung in paralleler Richtung zum von der elektrischen Spannung erzeugten elektrischen Feld aus. Piezokeramiken werden u.A. für Piezoaktoren verwendet, mittels derer beispielsweise das Einspritzen von Kraftstoff in einen Verbrennungsmotor gesteuert wird.

Piezokeramiken weisen elektrische Dipole auf, die zunächst unpolarisiert sind. Um den piezoelektrischen Effekt nutzbar zu machen, muss die Piezokeramik polarisiert werden.

Die DE 100 28 335 B4 offenbart ein Verfahren zum Polarisieren einer Piezokeramik, bei dem, ausgehend von einem Grundkörper aus unpolarisierter Piezokeramik mit wenigstens zwei flächig einander gegenüberliegenden Elektroden, eine Anzahl von Spannungspulsen an die Elektroden angelegt wird. Die Pulshöhen der Spannungspulse folgen einer zeitabhängigen Hüllkurve, die in einem ersten Abschnitt während einer Anstiegszeit von einer minimalen elektrischen Spannung auf eine maximale elektrische Spannung anwächst und die in einem zweiten Abschnitt während einer Haltezeit die maximale elektrische Spannung hält. Die minimale elektrische Spannung hat einen Wert, so dass beim Aufladen der Elektroden die maximal verträgliche Aufladung der noch unpolarisierten Piezokeramik unterschritten wird. Die maximale elektrische Spannung ist zur Ausbildung einer dauerhaften Polarisierung der Piezokeramik geeignet.

Aufgabe der Erfindung ist es, ein Verfahren zum Polarisieren einer Piezokeramik anzugeben, das ein schnelleres Polarisieren der unpolarisierten Piezokeramik ermöglicht.

Die Aufgabe der Erfindung wird gelöst durch ein Verfahren zum Polarisieren einer Piezokeramik, aufweisend folgende Verfahrensschritte:
- Bereitstellen eines Grundkörpers aus unpolarisierter Piezokeramik mit wenigstens zwei flächenhaft ausgebildeten einander gegenüberliegenden Elektroden und mit wenigstens einer Sollbruchstelle, aufgrund derer sich beim Anlegen einer elektrischen Spannung mit einem ersten elektrischen Spannungswert ein Entlastungsriss bildet, und
- Anlegen einer Anzahl von elektrischen Spannungspulsen an die Elektroden, deren Pulshöhen einer zeitabhängigen Hüllkurve folgen, wobei die Pulshöhen der elektrischen Spannungspulse in einem ersten Abschnitt der Hüllkurve größer als der erste elektrische Spannungswert sind und die Pulshöhen der elektrischen Spannungspulse in einem dem ersten Abschnitt nachfolgenden zweiten Abschnitt der Hüllkurve einen zweiten elektrischen Spannungswert aufweisen, der für eine dauerhafte Polarisation der Piezokeramik ausreicht.

Der Grundkörper aus unpolarisierter Piezokeramik ist z.B. vorgesehen, für einen Piezoaktor verwendet zu werden. Damit dies möglich ist, muss die unpolarisierte Piezokeramik polarisiert werden. Der Grundkörper weist ferner eine oder auch mehrere Sollbruchstellen auf, aufgrund derer sich beim Anlegen der ersten elektrischen Spannung ein oder mehrere Entlastungsrisse bilden. Durch die gezielte Führung dieser Entlastungsrisse durch z.B. poröse Keramikschichten oder poröse Elektrodenschichten kann die Lebensdauer eines den Grundkörper verwendenden Piezoaktors erhöht werden. Sollbruchstellen sind u.A. in der DE 10 2004 031 404 A1 und die DE 102 34 787 C1 offenbart.

Aufgrund der Sollbruchstellen ist es möglich, vor der Polarisierung der unpolarisierten Piezokeramik mittels der elektrischen Spannungspulsen des zweiten Abschnitts der Hüllkurve den Grundkörper aus unpolarisierter Piezokeramik mit den elektrischen Spannungspulsen des ersten Abschnitts der Hüllkurve zu beaufschlagen. Die elektrische Spannung des ersten Abschnitts (erster Spannungswert) ist größer, insbesondere deutlich größer als eine elektrische Spannung, bei deren Anlegen der oder die Entlastungsrisse entstehen.

Der erste Spannungswert kann insbesondere größer als der zweite Spannungswert sein, wodurch die Effizienz des erfindungsgemäßen Verfahrens gesteigert wird.

Die Führung des oder der Entlastungsrisse durch die porösen Schichten sorgen dann für eine gezielte Ausbreitung des bzw. der Entlastungsrisse bis hin zu einer Tiefe, ab der der oder die Entlastungsrisse nicht mehr zu einem schädlichen Abknicken neigen.

Unmittelbar nach dem Beaufschlagen des Grundkörpers mit den elektrischen Spannungspulsen des ersten Abschnitts der Hüllkurve kann der zweite Abschnitt der Hüllkurve beginnen. Der zweite Spannungswert ist hoch genug, dass er für eine dauerhafte Polarisation der Piezokeramik ausreicht. Der zweite Spannungswert ist z.B. abhängig von der Piezokeramik und/oder dem Abstand zwischen zwei Elektroden.

Der zweite elektrische Spannungswert kann gleich der maximal zulässigen elektrischen Spannung eines Piezoaktors sein, für den der Grundkörper vorgesehen ist. Dann ist der zweite Spannungswert der höhere Wert aus der elektrischen Spannung, mit der ein Aufladen für dauerhafte Polarisation erreicht wird oder aber die maximal zulässige elektrische Spannung des Piezoaktors.

Damit sich die Entlastungsrisse bilden, ist es nur nötig, die Spannungspulse mit dem ersten Spannungswert für eine relativ kurze Zeitdauer an den Grundkörper aus unpolarisierter Piezokeramik anzulegen. Nach einer Ausführungsform des erfindungsgemäßen Verfahrens ist daher die Zeitdauer des ersten Abschnitts kleiner als die Zeitdauer des zweiten Abschnitts. Insbesondere kann die Zeitdauer des ersten Abschnitts kleiner als oder gleich ein Viertel der Zeitdauer des zweiten Abschnitts betragen. Die Zeitdauer des zweiten Abschnitts der Hüllkurve, während der die Piezokeramik polarisiert wird, beträgt z.B. 60 Sekunden. In dieser Zeit wird der Grundkörper z.B. mit 6000 Spannungspulsen beaufschlagt. Die Zeitdauer des ersten Abschnitts, während der sich der oder die Entlastungsrisse bilden, kann dann beispielsweise 15 Sekunden betragen, während der der Grundkörper z.B. mit 1500 elektrischen Spannungspulsen beaufschlagt wird.

Der Grundkörper kann Verschmutzungen insbesondere in einer Passivierungsschicht aufweisen. Diese Verschmutzungen haben nicht notwendigerweise zur Folge, dass der Piezoaktor, für den der Grundkörper verwendet wird, funktionsuntüchtig ist. Nach einer weiteren Variante des erfindungsgemäßen Verfahrens weist daher die Hüllkurve einen dem ersten Abschnitt vorangehenden dritten Abschnitt auf, wobei die Pulshöhen der elektrischen Spannungspulse des dritten Abschnitts einen dritten Spannungswert aufweisen, der insbesondere kleiner als der zweite Spannungswert ist und ausreicht, diese Verschmutzung zu verbrennen. Die elektrischen Spannungspulse des dritten Abschnitts sind vorgesehen, an der Stelle der Verunreinigung gezielt einen elektrischen Überschlag zu erzeugen. Ein durch den Überschlag entstehender Funke kann die Verunreinigung verbrennen ohne eine leitfähige Brandstelle zu hinterlassen.

Die Zeitdauer, die nötig ist, damit die Verschmutzung verbrennt, kann ebenfalls relativ kurz gewählt werden. Gemäß einer Ausführungsform des erfindungsgemäßen Verfahrens ist die Zeitdauer des ersten und des dritten Abschnitts zusammen kleiner als die Zeitdauer des zweiten Abschnitts. Insbesondere kann die Zeitdauer des ersten und des dritten Abschnitts zusammen kleiner als oder gleich ein Viertel der Zeitdauer des zweiten Abschnitts betragen.

Der dritte Spannungswert (Spannung für die Verbrennung der Verunreinigung) kann z.B. ermittelt werden, indem zunächst die elektrische Leitfähigkeit des Grundkörpers aus unpolarisierter Piezokeramik ermittelt wird, wodurch auf den Grad der Verschmutzung insbesondere in der Passivierungsschicht geschlossen werden kann. Der dritte Spannungswert kann dann aufgrund des ermittelten Grades der Verunreinigung eingestellt werden.

Die Leitfähigkeit des Grundkörpers aus unpolarisierter Piezokeramik kann beispielsweise durch Anlegen einer elektrischen Spannung von insbesondere um die 10V an die Elektroden ermittelt werden.

Ist der dritte elektrische Spannungswert größer als oder gleich dem zweiten Spannungswert, dann wird der dritte Abschnitt nicht benötigt.

Die Absolutstabilität des Piezoaktors, für den der Grundkörper verwendet wird, kann erhöht werden, wenn während der Polarisierung der Piezokeramik zusätzlich die mittlere Kraft beim mittleren Hub wirkt, die der Piezoaktor im Betrieb ausgesetzt ist. Nach einer Ausführungsform des erfindungsgemäßen Verfahrens wird der Grundkörper daher während des Anlegens der elektrischen Spannungspulse mit einer gegen den Grundkörper wirkenden Kraft beaufschlagt, die insbesondere einem Mittelwert einer Kraft entspricht, gegen den ein Piezoaktor, für den der Grundkörper vorgesehen ist, im Betrieb bei einem mittleren Hub arbeitet. Dies kann beispielsweise erreicht werden, indem während des Anlegens der Spannungspulse der Grundkörper gegen eine applikationsnahe Federsteifigkeit oder eine definierte Kraft arbeitet.

Die Hüllkurve kann noch einen dem zweiten Abschnitt nachfolgenden vierten Abschnitt aufweisen, wobei die Pulshöhen der elektrischen Spannungspulse des vierten Abschnitts einen vierten Spannungswert aufweisen, der ein Mittelwert einer elektrischen Spannung entspricht, die im Betrieb eines Piezoaktors, für den der Grundkörper vorgesehen ist, angelegt wird. Die Zeitdauer des vierten Abschnitts kann kleiner als die Zeitdauer des zweiten Abschnitts sein. Insbesondere kann die Zeitdauer des vierten Abschnitts kleiner als oder gleich der Hälfte der Zeitdauer des zweiten Abschnitts betragen. Zeitlich besonderes effektiv kann das erfindungsgemäße Verfahren ausgeführt werden, wenn eine Polungsanlage für das Verfahren derart betrieben wird, dass eine Mechanik der Polungsanlage derart ausgeführt ist, dass beim Anlegen der Spannungspulse während des zweiten Abschnitts die Wirkung der Kraft trotz maximaler Spannung nur einem Injektionsmittelwert des Piezoaktors entspricht.

Ausführungsbeispiele der Erfindung sind exemplarisch in den beigefügten schematischen Zeichnungen dargestellt. Es zeigen:
- Fig. 1: einen Piezostapel mit unpolarisierter Piezokeramik,
- Fig. 2: den Piezostapel nach einem Polarisieren seiner Piezokeramik,
- Fig. 3: einen Verlauf einer elektrischen Spannung, mit der der Piezostapel beaufschlagt wird,
- Fig. 4: eine Hüllkurve der elektrischen Spannung,
- Fig. 5: einen alternativen Verlauf einer elektrischen Spannungen, mit der der Piezostapel der Fig. 1 beaufschlagt werden kann,
- Fig. 6: eine Hüllkurve der elektrischen Spannung der Fig. 5,
- Fig. 7: einen weiteren Verlauf einer elektrischen Spannungen, mit der der Piezostapel der Fig. 1 beaufschlagt werden kann, und
- Fig. 8: eine Hüllkurve der elektrischen Spannung der Fig. 7.

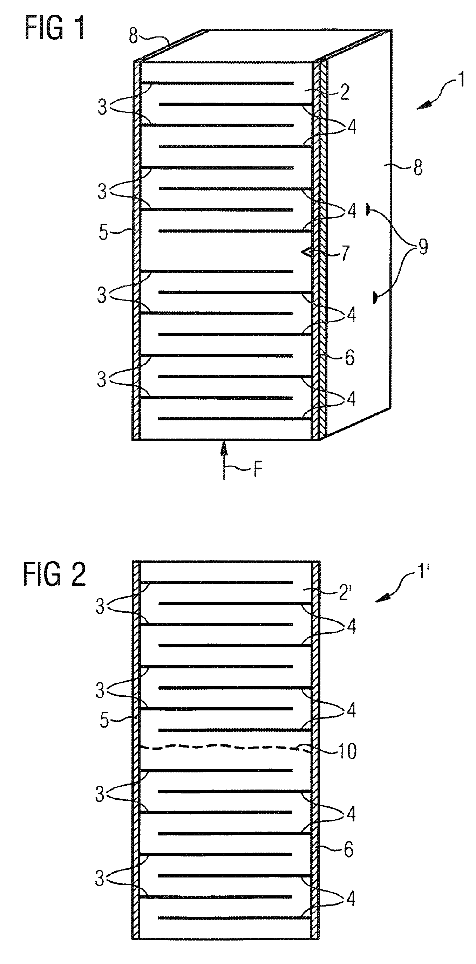

Die Fig. 1 zeigt einen im Falle des vorliegenden Ausführungsbeispieles quaderförmig ausgeführten Piezostapel 1 (Grundkörper) in einer teilweise geschnittenen und perspektivischen Darstellung. Der Piezostapel 1 weist eine schichtförmig ausgebildete unpolarisierte Piezokeramik 2 und mehrere innerhalb der unpolarisierten Piezokeramik 2 angeordnete Innenelektroden 3, 4 auf und wurde in Allgemein bekannter Weise, beispielsweise durch die Prozessschritte Stapeln, Trennen, Entbindern und Schleifen erzeugt. Die Piezokeramik 2 weist beispielsweise Blei-Zirkonat-Titanat auf und bei den Innenelektroden 3, 4 handelt es sich im Falle des vorliegenden Ausführungsbeispiels um elektrisch leitfähige Metallschichten, die den Piezostapel 1 durchsetzen.

Im Falle des vorliegenden Ausführungsbeispiels sind die Innenelektroden 3, 4 abwechselnd mit an gegenüberliegenden Au-βenflächen des Piezostapels 1 angeordneten und direkt auf der Mantelfläche der Piezokeramik 2 aufgebrachten Außenelektroden 5, 6 elektrisch verbunden. Die Innenelektroden 3, 4, die mit einer der beiden Außenelektroden 5, 6 elektrisch verbunden sind, sind daher bis zu der Außenseite, an der diese Außenelektrode 5, 6 angeordnet ist, für die elektrische Verbindung mit der Außenelektrode 5, 6 herangeführt. Damit die Innenelektroden 3, 4 jedoch von der anderen Außenelektrode 5, 6 elektrisch isoliert sind, reichen die Innenelektroden 3, 4 nicht bis zu der Außenseite des Piezostapels 1 heran, an der die andere Außenelektrode 5, 6 angeordnet ist.

Im Falle des vorliegenden Ausführungsbeispiels ist die Mantelfläche des Piezostapels 1 außerdem mit einer Passivierungsschicht 8 versehen, die Verunreinigungen 9 enthalten kann.

Im Falle des vorliegenden Ausführungsbeispiels weist der Piezostapel 1 ferner eine Sollbruchstelle 7 auf, aufgrund derer sich beim Überschreiten einer an den Innenelektroden 3, 4 angelegten elektrischen Spannung ein in der Figur 2 gezeigter Entlastungsriss 10 bildet.

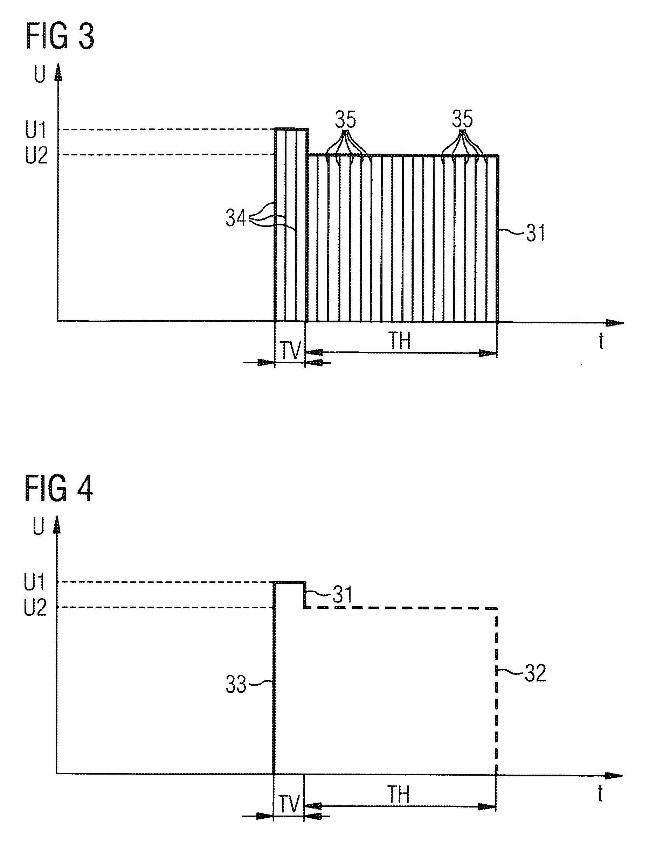

Die Piezokeramik 2 des in der Fig. 1 dargestellten Piezostapels 1 sind noch unpolarisiert und müssen, damit sie einen piezoelektrischen Effekt aufweisen, polarisiert werden. Dies wird durch Anlegen einer elektrischen Spannung U an die Innenelektroden 3, 4 bzw. den Außenelektroden 5, 6 erreicht, deren Verlauf in der Figur 3 dargestellt ist.

Im Falle des vorliegenden Ausführungsbeispiels handelt es sich bei der an den Piezostapel 1 angelegten elektrischen Spannung U um elektrische Spannungspulse 34, 35, deren Pulshöhen einer zeitabhängigen Hüllkurve 31 folgen. Die Hüllkurve 31, die in der Fig. 4 nochmals gezeigt ist, weist einen in der Fig. 4 mit einer durchgezogenen Linie angedeuteten ersten Abschnitt 33 und einen in der Fig. 4 gestrichelt angedeuteten zweiten Abschnitt 32 auf.

Im Falle des vorliegenden Ausführungsbeispiels umfasst der zweite Abschnitt 32 der Hüllkurve 31 6000 einzelne Pulse 35, die jeweils dieselbe Pulshöhe mit einer elektrischen Spannung U2 aufweisen. Die Zeitdauer TH der zweiten Hüllkurve 32 beträgt z.B. 60 Sekunden. Die elektrische Spannung U2 ist ausreichend, um die unpolarisierte Piezokeramik 2 zu polarisieren und hat im Falle des vorliegenden Ausführungsbeispiels einen Wert von ca. 160V. Ist die maximal zulässige elektrische Spannung eines nicht näher dargestellten Piezoaktors, für den der Piezostapel 1 vorgesehen ist, ausreichend für die Polarisierung der unpolarisierten Piezokeramik 2, dann können die Pulshöhen des zweiten Abschnitts 32 gleich dieser maximal zulässigen Spannung sein.

Die Zeitdauer TV des ersten Abschnitts 33 ist im Falle des vorliegenden Ausführungsbeispiels deutlich kürzer als die Zeitdauer TH des zweiten Abschnitts 32 und beträgt z.B. 15 Sekunden und umfasst beispielsweise 1500 einzelne Pulse 34. Die elektrische Spannung U1 für die Pulshöhen der Pulse 34 des ersten Abschnitts ist derart gewählt, dass sie größer als eine Spannung sind, aufgrund derer sich der Entlastungsriss 10 bildet. Im Falle des vorliegenden Ausführungsbeispiels beträgt die Spannung U1 von ca. 200V.

Somit entsteht, nachdem der Piezostapel 1 mit der elektrischen Spannung beaufschlagt wurde, ein in de Fig. 2 gezeigte Piezostapel 1' mit polarisierter Piezokeramik 2'.

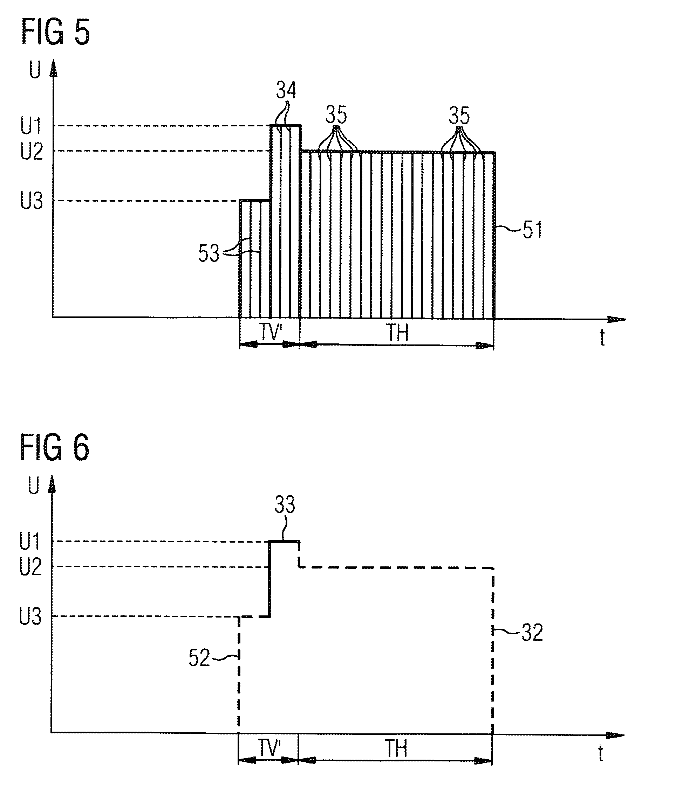

Die Fig. 5 zeigt einen alternativen Spannungsverlauf zum Polarisieren der unpolarisierten Piezokeramik 2 des Piezostapels 1. Bei dem in der Fig. 4 gezeigten Spannungsverlauf handelt es sich um die elektrischen Spannungspulse 34, 35 und zusätzlich um Spannungspulse 53, deren Pulshöhen zusammen einer zeitabhängigen Hüllkurve 51 folgen. Die Hüllkurve 51, die in der Fig. 6 nochmals gezeigt ist, weist zusätzlich zu der in de Fig. 4 gezeigten Hüllkurve 31 einen in der Fig. 6 gestrichelt angedeuteten dritten Abschnitt 52 auf, der dem ersten Abschnitt 33 voran geht.

Im Falle des vorliegenden Ausführungsbeispiels sind die Zeitdauern TV' des ersten und des dritten Abschnitts 33, 52 zusammen deutlich kürzer als die Zeitdauer TH des zweiten Abschnitts 32 und betragen z.B. 15 Sekunden. Der erste Abschnitt 32 und der dritte Abschnitt 52 weisen jeweils z.B. 750 einzelne Pulse 34, 53 auf. Die Pulshöhen des ersten Abschnitts 34 haben einen Spannungswert U1, so dass sich der Entlastungsriss 10 bildet.

Insbesondere die Passivierungsschicht 8 kann die Verunreinigungen 9 aufweisen. Diese werden im Falle des vorliegenden Ausführungsbeispiels durch die Spannungspulse 53 des dritten Abschnitts 52 verbrannt. Die Pulshöhen mit einer elektrischen Spannung U3 der elektrischen Spannungspulse 53 des dritten Abschnitts 52 sind dabei geringer als die Spannung U2 des zweiten Abschnitts 32. Die Höhe der Spannung U3 der Spannungspulse 53 des dritten Abschnitts 52 wird z.B. ermittelt, indem zunächst die elektrische Leitfähigkeit des Piezostapels 1 aus unpolarisierter Piezokeramik 2 ermittelt wird, wodurch auf den Grad der Verschmutzung 9 in der Passivierungsschicht 8 geschlossen werden kann. Die Spannung U3 kann dann aufgrund des ermittelten Grades der Verunreinigung 9 eingestellt werden. Die Leitfähigkeit des Piezostapels 1 aus unpolarisierter Piezokeramik 2 kann beispielsweise durch Anlegen einer elektrischen Spannung von insbesondere um die 10V an die Innenelektroden 3, 4 ermittelt werden.

Somit entsteht, nachdem der Piezostapel 1 mit der elektrischen Spannung beaufschlagt wurde, der in der Fig. 2 gezeigte Piezostapel 1' mit polarisierter Piezokeramik 2'.

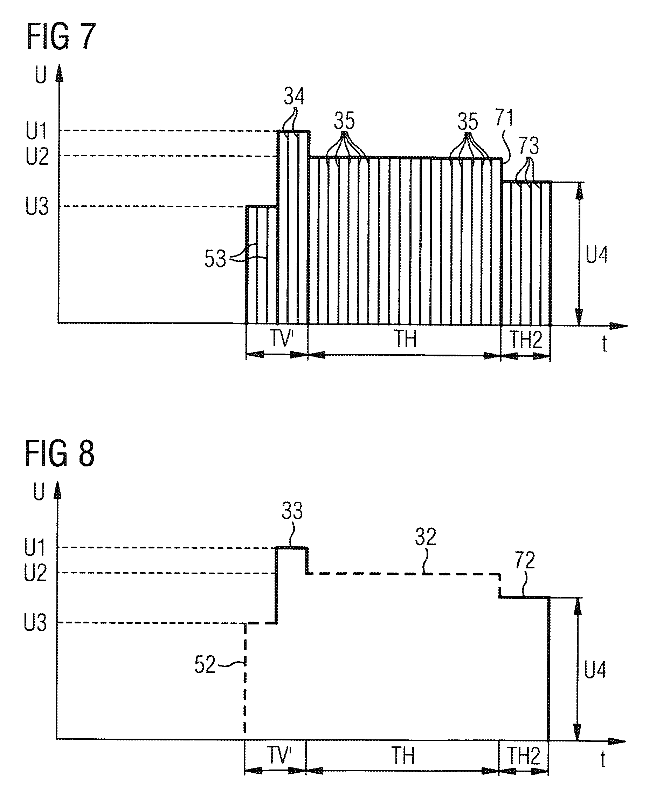

Die Fig. 7 zeigt einen alternativen Spannungsverlauf zum Polarisieren der unpolarisierten Piezokeramik 2 des Piezostapels 1. Bei dem in der Fig. 7 gezeigten Spannungsverlauf handelt es sich um die elektrische Spannungspulse 34, 35, 53 und weiteren Spannungspulsen 73, deren Pulshöhen zusammen einer zeitabhängigen Hüllkurve 71 folgen. Die Hüllkurve 71, die in der Fig. 8 nochmals gezeigt ist, weist zusätzlich zu der in de Fig. 6 gezeigten Hüllkurve 51 einen in der Fig. 8 mittels einer durchgezogenen Linie dargestellten vierten Abschnitt 72 auf, der dem zweiten Abschnitt 32 nachfolgt.

Im Falle des vorliegenden Ausführungsbeispiels umfasst der vierte Abschnitt 72 der Hüllkurve 71 3000 einzelne Pulse 75, deren Pulshöhe eine elektrische Spannung U4 aufweisen. Die Zeitdauer TH2 des vierten Abschnitts 72 beträgt z.B. 30 Sekunden. Die Spannung U4 für die Spannungspulse 73 des vierten Abschnitts 72 entsprechen dem Mittelwert einer elektrischen Spannung, die im Betrieb des Piezoaktors, für den der Piezostapel 1 vorgesehen ist, angelegt wird.

Somit entsteht, nachdem der Piezostapel 1 mit der elektrischen Spannung beaufschlagt wurde, der in der Fig. 2 gezeigte Piezostapel 1' mit polarisierter Piezokeramik 2'.

Im Falle der vorliegenden Ausführungsbeispiele wird während der Polarisierung der unpolarisierten Piezokeramik 2, d.h. während des Beaufschlagen des Piezostapels 1 mit der elektrischen Spannung, dieser mit der mittleren Kraft F beim mittleren Hub, die der Piezoaktor, für den der Piezostapel 1 vorgesehen ist, im Betrieb ausgesetzt ist, beaufschlagt. Dies kann beispielsweise erreicht werden, indem während des Anlegens der Spannungspulse 34, 35, 53, 73 der Piezostapel 1 gegen eine applikationsnahe Federsteifigkeit oder eine definierte Kraft arbeitet.

## Patentansprüche

1. Verfahren zum Polarisieren einer Piezokeramik, aufweisend folgende Verfahrensschritte:
- Bereitstellen eines Grundkörpers (1) aus unpolarisierter Piezokeramik (2) mit wenigstens zwei flächenhaft ausgebildeten einander gegenüberliegenden Elektroden (3, 4) und mit wenigstens einer Sollbruchstelle (7), aufgrund derer sich beim Anlegen einer elektrischen Spannung mit einem ersten elektrischen Spannungswert ein Entlastungsriss (10) bildet, und
- Anlegen einer Anzahl von elektrischen Spannungspulsen (34, 35, 53, 73) an die Elektroden (3, 4), deren Pulshöhen einer zeitabhängigen Hüllkurve (31, 51, 71) folgen, wobei die Pulshöhen der elektrischen Spannungspulse (34, 35, 53, 73) in einem ersten Abschnitt (33) der Hüllkurve (31, 51, 71) größer als der erste elektrische Spannungswert sind und die Pulshöhen der elektrischen Spannungspulse (35) in einem dem ersten Abschnitt (33) nachfolgenden zweiten Abschnitt (32) der Hüllkurve (31) einen zweiten elektrischen Spannungswert (U2) aufweisen, der für eine dauerhafte Polarisation der Piezokeramik (2) ausreicht.

2. Verfahren nach Anspruch 1,
**dadurch gekennzeichnet,**
**dass** der erste elektrische Spannungswert größer als der zweite elektrische Spannungswert (U2) ist.

3. Verfahren nach Anspruch 1 oder 2,
**dadurch gekennzeichnet,**
**dass** der zweite elektrische Spannungswert (U2) gleich der maximal zulässigen elektrischen Spannung eines Piezoaktors ist, für den der Grundkörper (1) vorgesehen ist.

4. Verfahren nach einem der Ansprüche 1 bis 3,
**dadurch gekennzeichnet,**
**dass** die Zeitdauer (TV) des ersten Abschnitts (33) kleiner als die Zeitdauer (TH) des zweiten Abschnitts (32) ist, insbesondere, dass die Zeitdauer (TV) des ersten Abschnitts (33) kleiner als oder gleich ein Viertel der Zeitdauer (TH) des zweiten Abschnitts (32) beträgt.

5. Verfahren nach einem der Ansprüche 1 bis 4,
**dadurch gekennzeichnet,**
**dass** die Hüllkurve (51, 71) einen dem ersten Abschnitt (33) vorangehenden dritten Abschnitt aufweist, wobei die Pulshöhen der elektrischen Spannungspulse (53) des dritten Abschnitts (52) einen dritten Spannungswert (U3) aufweisen, der kleiner als der zweite Spannungswert (U2) ist und ausreicht, eine Verschmutzung (9) insbesondere in einer Passivierungsschicht (8) des Grundkörpers (1) zu verbrennen.

6. Verfahren nach Anspruch 5,
**dadurch gekennzeichnet,**
**dass** die Zeitdauer (TV') des ersten und des dritten Abschnitts (33, 52) zusammen kleiner als die Zeitdauer (TH) des zweiten Abschnitts (32) ist, insbesondere, dass die Zeitdauer (TV') des ersten und des dritten Abschnitts (33, 52) zusammen kleiner als oder gleich ein Viertel der Zeitdauer (TH) des zweiten Abschnitts (32) beträgt.

7. Verfahren nach Anspruch 5 oder 6,
**gekennzeichnet durch**
Ermitteln der elektrischen Leitfähigkeit des Grundkörpers (1) aus unpolarisierter Piezokeramik (2), Schließen auf den Grad der Verschmutzung (9) und Einstellen des dritten Spannungswertes (U3) aufgrund des ermittelten Grades der Verunreinigung (9).

8. Verfahren nach Anspruch 7,
**gekennzeichnet durch**
Anlegen einer elektrischen Spannung von insbesondere um die 10V an die Elektroden (3, 4), um die elektrische Leitfähigkeit des Grundkörpers (1) aus unpolarisierter Piezokeramik (2) zu ermitteln.

9. Verfahren nach einem der Ansprüche 1 bis 8, **gekennzeichnet durch**
Beaufschlagen des Grundkörpers (1) während des Anlegens der elektrischen Spannungspulse (34, 35, 53, 73) mit einer gegen den Grundkörper (1) wirkenden Kraft (F), die insbesondere einem Mittelwert einer Kraft entspricht, gegen den ein Piezoaktor, für den der Grundkörper (1) vorgesehen ist, im Betrieb bei einem mittleren Hub arbeitet.

10. Verfahren nach einem der Ansprüche 1 bis 9,
**dadurch gekennzeichnet,**
**dass** die Hüllkurve (71) einen dem zweiten Abschnitt (32) nachfolgenden vierten Abschnitt (72) aufweist, wobei die Pulshöhen der elektrischen Spannungspulse (73) des vierten Abschnitts (72) einen vierten Spannungswert (U4) aufweisen, der ein Mittelwert einer elektrischen Spannung entspricht, die im Betrieb eines Piezoaktors, für den der Grundkörper (1) vorgesehen ist, angelegt wird.

11. Verfahren nach Anspruch 10,
**dadurch gekennzeichnet,**
**dass** die Zeitdauer (TH2) des vierten Abschnitts (72) kleiner als die Zeitdauer (TH) des zweiten Abschnitts (32) ist, insbesondere dass die Zeitdauer (TH2) des vierten Abschnitts (72) kleiner als oder gleich der Hälfte der Zeitdauer (TH) des zweiten Abschnitts (32) beträgt.

## Claims

1. Method for polarising a piezoceramic material, comprising the following method steps of:
- providing a main body (1) made from unpolarised piezoceramic material (2) having at least two electrodes (3, 4) embodied with flat surfaces and disposed opposite each other, and having at least one predetermined fracture joint (7) due to which a strain-relieving crack (10) forms when an electrical voltage having a first electrical voltage value is applied, and
- applying a number of electrical voltage pulses (34, 35, 53, 73) to the electrodes (3, 4), the pulse heights of which voltage pulses follow a time-dependent envelope curve (31, 51, 71), wherein the pulse heights of the electrical voltage pulses (34, 35, 53, 73) in a first section (33) of the envelope curve (31, 51, 71) are greater than the first electrical voltage value and the pulse heights of the electrical voltage pulses (35) in a second section (32) of the envelope curve (31) following the first section (33) have a second electrical voltage value (U2) which is sufficient to produce a permanent polarisation of the piezoceramic material (2).

2. Method according to claim 1,
**characterised in that**
the first electrical voltage value is greater than the second electrical voltage value (U2).

3. Method according to claim 1 or 2,
**characterised in that**
the second electrical voltage value (U2) is equal to the maximum permissible electrical voltage of a piezoelectric actuator for which the main body (1) is provided.

4. Method according to one of claims 1 to 3, **characterised in that**
the time period (TV) of the first section (33) is less than the time period (TH) of the second section (32), in particular in that the time period (TV) of the first section (33) is less than or equal to a quarter of the time period (TH) of the second section (32).

5. Method according to one of claims 1 to 4, **characterised in that**
the envelope curve (51, 71) has a third section preceding the first section (33), with the pulse heights of the electrical voltage pulses (53) of the third section (52) having a third voltage value (U3) which is less than the second voltage value (U2) and is sufficient to incinerate a contaminant (9) in particular in a passivation layer (8) of the main body (1).

6. Method according to claim 5,
**characterised in that**
the time period (TV') of the first and the third section (33, 52) together is less than the time period (TH) of the second section (32), in particular **in that** the time period (TV') of the first and the third section (33, 52) together is less than or equal to a quarter of the time period (TH) of the second section (32).

7. Method according to claim 5 or 6,
**characterised by**
determining the electrical conductivity of the main body (1) made from unpolarised piezoceramic material (2), deducing the degree of contamination (9) and setting the third voltage value (U3) based on the determined degree of contamination (9) .

8. Method according to claim 7,
**characterised by**
applying an electrical voltage of in particular around 10V to the electrodes (3, 4) in order to determine the electrical conductivity of the main body (1) made from unpolarised piezoceramic material (2).

9. Method according to one of claims 1 to 8, **characterised by**
applying to the main body (1), while the electrical voltage pulses (34, 35, 53, 73) are being applied, a force (F) acting against the main body (1), which force (F) corresponds in particular to a mean value of a force against which a piezoelectric actuator for which the main body (1) is provided works at a mean stroke during operation.

10. Method according to one of claims 1 to 9, **characterised in that**
the envelope curve (71) has a fourth section (72) following the second section (32), with the pulse heights of the electrical voltage pulses (73) of the fourth section (72) having a fourth voltage value (U4) which corresponds to a mean value of an electrical voltage that is applied during the operation of a piezoelectric actuator for which the main body (1) is provided.

11. Method according to claim 10,
**characterised in that**
the time period (TH2) of the fourth section (72) is less than the time period (TH) of the second section (32), in particular in that the time period (TH2) of the fourth section (72) is less than or equal to half of the time period (TH) of the second section (32).

## Revendications

1. Procédé de polarisation d'un élément piézocéramique, comportant les étapes de procédé suivantes :
- la préparation d'un corps de base (1) formé d'un élément piézocéramique (2) non polarisé comprenant au moins deux électrodes planes (3, 4) disposées l'une en face de l'autre et avec au moins un point destiné à la rupture (7), qui fait qu'il se forme une fente de décharge (10) lors de l'application d'une tension électrique présentant une première valeur de tension électrique, et
- l'application aux électrodes (3, 4) d'un certain nombre d'impulsions de tension électrique (34, 35, 53, 73), dont les amplitudes suivent une enveloppe (31, 51, 71) fonction du temps, où les amplitudes des impulsions de tension électrique (34, 35, 53, 73) dans une première section (33) de l'enveloppe (31, 51, 71) sont supérieures à la première valeur de tension électrique et les amplitudes des impulsions de tension électrique (35) présentent, dans une deuxième section (32) de l'enveloppe succédant à la première section (33), une deuxième valeur de tension électrique (U2), qui suffit pour obtenir une polarisation durable de l'élément piézocéramique (2).

2. Procédé selon la revendication 1,
**caractérisé en ce que**
la première valeur de tension électrique est supérieure à la deuxième valeur de tension électrique (U2).

3. Procédé selon la revendication 1 ou 2, **caractérisé en ce que**
la deuxième valeur de tension électrique (U2) est identique à la tension électrique maximale autorisée d'un actionneur piézoélectrique, pour lequel est prévu le corps de base (1).

4. Procédé selon l'une quelconque des revendications 1 à 3,
**caractérisé en ce que**
la durée (TV) de la première section (33) est inférieure à la durée (TH) de la deuxième section (32), en particulier **en ce que** la durée (TV) de la première section (33) est inférieure ou égale à un quart de la durée (TH) de la deuxième section (32).

5. Procédé selon l'une quelconque des revendications 1 à 4,
**caractérisé en ce que**
l'enveloppe (51, 71) présente une troisième section précédant la première section (33), dans lequel les amplitudes des impulsions de tension électrique (53) de la troisième section (52) présentent une troisième valeur de tension (U3), qui est inférieure à la deuxième valeur de tension (U2) et qui suffit pour brûler une salissure (9), en particulier dans une couche de passivation (8) du corps de base (1).

6. Procédé selon la revendication 5,
**caractérisé en ce que**
la durée (TV') réunie des première et troisième sections (33, 52) est inférieure à la durée (TH) de la deuxième section (32), en particulier **en ce que** la durée (TV') réunie des première et troisième sections (33, 52) est inférieure ou égale à un quart de la durée (TH) de la deuxième section (32).

7. Procédé selon la revendication 5 ou 6, **caractérisé par**
la détermination de la conductivité électrique du corps de base (1) constitué d'un élément piézocéramique non polarisé, l'établissement du degré de salissure (9) et le réglage de la troisième valeur de tension (U3) en raison du degré déterminé de l'impureté (9).

8. Procédé selon la revendication 7,
**caractérisé par**
l'application d'une tension électrique en particulier de 10 V aux électrodes (3, 4) pour déterminer la conductivité électrique du corps de base (1) constitué d'un élément piézocéramique (2) non polarisé.

9. Procédé selon l'une quelconque des revendications 1 à 8,
**caractérisé par**
la sollicitation du corps de base (1) pendant l'application des impulsions de tension électrique (34, 35, 53, 73) par une force (F) agissant contre le corps de base (1), laquelle force correspond en particulier à une valeur moyenne d'une force, contre lequel un actionneur piézoélectrique, pour lequel est prévu le corps de base (1), travaille en service lors d'une course moyenne.

10. Procédé selon l'une quelconque des revendications 1 à 9,
**caractérisé en ce que**
l'enveloppe (71) présente une quatrième section (72) succédant à la deuxième section (32), dans lequel les amplitudes des impulsions de tension électrique (73) de la quatrième section (72) présentent une quatrième valeur de tension (U4), qui correspond à une valeur moyenne d'une tension électrique, qui est appliquée lors du fonctionnement d'un actionneur piézoélectrique, pour lequel est prévu le corps de base (1).

11. Procédé selon la revendication 10, **caractérisé en ce que**
la durée (TH2) de la quatrième section (72) est inférieure à la durée (TH) de la deuxième section (32), en particulier **en ce que** la durée (TH2) de la quatrième section (72) est inférieure ou égale à la moitié de la durée (TH) de la deuxième section (32).
